# FASCICULE DE BREVET EUROPEEN

(11) **EP 0 954 021 B1**
(45) Date de publication et mention de la délivrance du brevet: **08.03.2006**
(21) Numéro de dépôt: 99400658.3
(22) Date de dépôt: 17.03.1999
(51) Int. Cl.: H01L 21/60, H01L 21/56

(54) **Procédé de réalisation d'un composant électronique**
Verfahren zum Herstellen eines elektronischen Bauelementes
Method for making an electronic component

(30) Priorité: 30.04.1998 FR 9805484
(43) Date de publication de la demande: 03.11.1999
(73) Titulaire: Axalto S.A., 92120 Montrouge (FR)
(72) Inventeur: Girard, Sophie, 45100 Orléans (FR); Vere, Denis, 45100 Orléans (FR)
(74) Mandataire: Cassagne, Philippe M.J.

(56) Documents cités:
- EP-A- 0 449 496
- EP-A- 0 704 899
- EP-A- 0 810 649
- WO-A-97/27646
- US-A- 4 955 132
- US-A- 5 672 542

## Description

La présente invention a pour objet un procédé de réalisation d'un composant électronique.

De façon plus précise, l'invention concerne la réalisation d'un tel composant qui comprend un substrat isolant muni de pistes conductrices et au moins une puce semi-conductrice montée sur ledit substrat isolant.

Il existe de nombreux cas dans lesquels on est amené à monter une puce semi-conductrice sur un circuit imprimé notamment de dimension réduite. C'est par exemple le cas pour les cartes à mémoire électronique, que ces cartes soient du type à contact ou du type sans contact, c'est-à-dire du type dans lequel la transmission de l'information et de l'énergie entre la carte et le lecteur est réalisée par onde électromagnétique.

Dans le cas d'une carte à mémoire électronique à contact, les pistes conductrices du circuit imprimé servent à relier les plages de contact externes de la carte aux bornes de la puce semi-conductrice pour réaliser un module électronique. Dans le cas d'une carte sans contact, les métallisations servent à constituer l'antenne de la carte et à relier celle-ci à la puce semi-conductrice.

Pour toutes ces applications et encore beaucoup d'autres, dans les solutions connues, pour réaliser les pistes conductrices du circuit imprimé, on dépose ou fixe sur un support isolant souple ou rigide un motif en cuivre consistant soit dans l'inclusion de fils de cuivre ou d'un autre métal, soit dans le dépôt d'un film de cuivre qui est ensuite gravé chimiquement pour obtenir les pistes souhaitées. A partir de ce circuit imprimé, on vient fixer la puce sur la zone.

Le brevet US 5, 566, 441 décrit un procédé de réalisation d'un composant électronique de type carte à puce, dans lequel une antenne est sérigraphiée sur un substrat, puis des bossages ou « bumps » conducteurs, comprenant un mélange d'un matériau conducteur et d'un matériau adhésif, sont appliqués sur les plages de contact de l'antenne, et enfin une puce est reportée de sorte que ses bornes de contact en saillie viennent en contact respectivement avec les bumps en adhésif conducteur réalisés sur les plages de contact de l'antenne. Les bumps en adhésif conducteur permettent ainsi d'assurer à la fois un contact électrique et une bonne fixation mécanique de la puce et de l'antenne.

La demande de brevet WO97/27646 décrit une méthode pour réaliser une interconnexion efficace entre une puce et un autre composant électronique. Pour cela, un adhésif conducteur est dispensé sur les bornes conductrices de la puce. La puce est ensuite reportée sur l'autre composant de sorte que l'adhésif dispensé sur ses bornes conductrices soit aligné face à des pistes conductrices de l'autre composant. Une pression est ensuite exercée sur les deux composants de manière à ce que l'adhésif conducteur assure une fixation mécanique et un contact électrique entre les différentes pistes et bornes conductrices.

Il s'avère que ces solutions techniques de réalisation du circuit imprimé sont relativement onéreuses. Or, on sait que notamment dans le cas de la réalisation de cartes à mémoire électronique avec ou sans contact, le coût de fabrication de la carte et donc celui du module comportant la pastille semi-conductrice doit être aussi réduit que possible.

Un objet de l'invention est de fournir un procédé de réalisation d'un composant électronique constitué par un élément de circuit imprimé sur lequel est fixée au moins une puce ou pastille semi-conductrice dont le coût de fabrication soit réduit par rapport aux techniques connues.

Pour atteindre ce but, selon l'invention, le procédé de réalisation d'un composant électronique du carte à puce comprenant un substrat isolant muni de pistes conductrices formant antenne et une puce semi-conductrice montée sur ledit substrat, se caractérise en ce qu'il comprend les étapes suivantes :
on réalise par sérigraphie lesdites pistes conductrices formant antenne sur le substrat à l'aide d'une encre conductrice polymérisable,
on fournit ladite puce semi-conductrice munie de plages de contact,
on réalise sur au moins certaines desdites plages des bornes conductrices en relief, et
on dispose ladite puce sur le substrat, alors que ladite encre conductrice des pistes conductrices formant antenne n'est pas encore sèche de telle manière que l'extrémité desdites bornes pénètre dans l'encre aux emplacements correspondants.
Avantageusement, on fixe mécaniquement ladite puce sur ledit substrat par polymérisation d'une résine adhésive isolante disposée entre la face inférieure de la puce et la face supérieure du substrat.

On comprend que la réalisation des pistes conductrices du circuit imprimé par sérigraphie à l'aide d'une encre conductrice permet de réduire très sensiblement le coût par rapport aux techniques classiques utilisant un dépôt métallique devant être gravé ou l'application d'une feuille de cuivre prédécoupée.

On comprend également que grâce au fait que la puce semi-conductrice munie de ces bornes de connexion en saillie soit mise en place alors que les pistes conductrices réalisées à l'aide de l'encre sérigraphiée ne sont pas encore sèches permet d'assurer un très bon contact électrique entre la puce et les pistes conductrices sans cependant nécessiter l'utilisation d'une colle conductrice comme dans les techniques antérieures.

Selon un premier mode de mise en oeuvre, la résine adhésive est déposée par capillarité entre le substrat et la puce après la mise en place de la puce sur le substrat.

Selon un deuxième mode de mise en oeuvre, la résine adhésive isolante est disposée sur la face inférieure de la puce avant la mise en place de celle-ci sur le substrat.

Un autre objet de l'invention est de fournir un composant électronique comprenant un substrat isolant muni de pistes conductrices réalisées avec une encore conductrice, une puce semi-conductrice munie de plages de contact et des moyens de fixation mécanique de la puce sur le substrat, caractérisé en ce que au moins certaines plages de contact sont munies d'une borne conductrice en relief, et en ce que l'extrémité des bornes conductrices pénètre dans l'encre conductrice servant à la réalisation desdites pistes.

On comprend qu'on a ainsi un composant dans lequel la liaison électrique entre la puce et les pistes conductrices résulte de la pénétration des extrémités des bornes conductrices dans l'encre formant les pistes conductrices.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées, sur lesquelles :
la figure 1 est une vue en coupe verticale d'une puce semi-conductrice fixée sur un circuit imprimé conforme à l'invention ;
la figure 2 est une vue de dessus d'un exemple de réalisation d'un composant consistant en une antenne associée à une puce ;
la figure 3 est une vue de dessus d'un premier mode de réalisation de l'écran de sérigraphie pour réaliser les pistes conductrices ; et
les figures 4a et 4b sont des vues partielles illustrant un deuxième mode de réalisation de l'écran de sérigraphie.

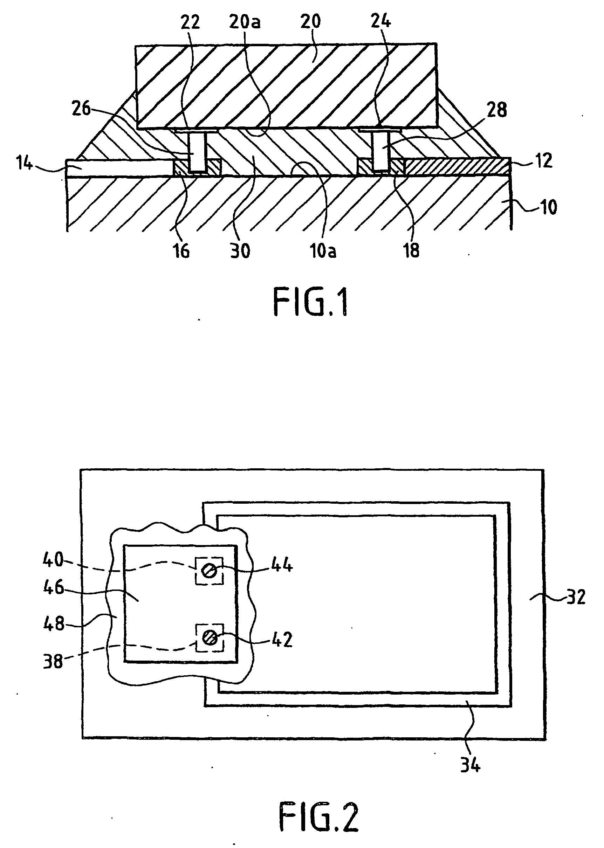

En se référant tout d'abord à la figure 1, on va décrire les différentes étapes du procédé de réalisation du composant électronique constitué par le circuit imprimé et une puce semi-conductrice. Dans un premier temps, on réalise sur un substrat isolant 10 qui peut être souple ou rigide des pistes conductrices 12, 14 qui constituent également des bornes 16, 18 de connexion de la puce semi-conductrice 20 avec les pistes conductrices 12 et 14. Selon une caractéristique essentielle de l'invention, les pistes conductrices 12, 14 sont réalisées par sérigraphie d'une encre conductrice à travers un écran. On expliquera ultérieurement plus en détail le mode de réalisation de l'opération de sérigraphie. Ces encres connues en elles-mêmes sont des composés polymérisables thermoplastiques ou thermodurcissables chargés en particules métalliques.

Par ailleurs, sur la face postérieure 20a de la puce semi-conductrice 20 et en regard de ces plages de contact 22 et 24, on réalise des bornes de connexion en relief telles que 26 et 28. Ces bornes sont désignées le plus souvent par le terme anglosaxon de bump. Avantageusement, les bornes en relief 26 et 28 peuvent être obtenues par une technique de sérigraphie d'une encre conductrice sur la face postérieure 20a de la puce semi-conductrice.

Après avoir réalisé les pistes conductrices 12 et 14 et avoir réalisé les bumps 26 et 28, on met en place la puce semi-conductrice 20 de telle manière que les bornes 26 et 28 soient en regard des plages de connexion 16 et 18 des pistes conductrices. La mise en place est réalisée alors que l'encre sérigraphiée constituant les pistes conductrices n'est pas encore sèche, c'est-à-dire qu'elle est encore dans un état visqueux, non encore totalement solidifié. On peut ainsi obtenir la pénétration de l'extrémité libre des bornes 26 et 28 dans l'encre conductrice, assurant ainsi un très bon contact électrique entre ces deux organes. Dans une étape ultérieure, on introduit entre la face postérieure 20a de la puce 20 et la face supérieure 10a du substrat 10 une résine isolante adhésive 30. Cette résine permet par polymérisation d'assurer la liaison mécanique entre le substrat 10 et la puce 20.

On comprend qu'on obtient ainsi l'ensemble souhaité constitué par le substrat 10, ces pistes conductrices 12, 14 et la puce semi-conductrice 20 qui est connectée électriquement aux pistes conductrices et qui est solidarisée mécaniquement avec le substrat.

En variante, on peut déposer sur la face inférieure de la puce une couche de matériau adhésif isolant et mettre en place la puce ainsi préparée sur le substrat.

Sur la figure 2, on a représenté un exemple de composants électroniques réalisables par la technique indiquée ci-dessus. Sur cette figure, on a montré le substrat isolant 32 sur lequel est réalisée une piste conductrice fermée sensiblement rectangulaire 34 qui constitue une antenne. Cette piste conductrice 34 comporte deux plages de connexion 38 et 40 pour des bornes de connexion 42 et 44 d'une puce semi-conductrice 46. On a fait figurer également sur cette figure le matériau adhésif isolant 48.

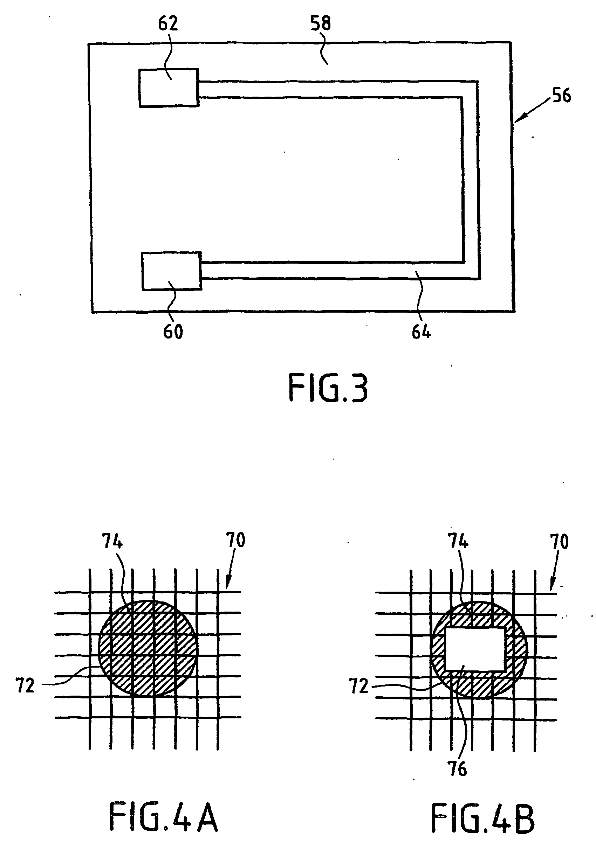

En se référant maintenant à la figure 3, on va décrire un premier mode de réalisation de l'écran 56 servant à réaliser par sérigraphie la piste conductrice 34 avec ses plages de connexion 38 et 40. Le masque 56 est constitué par une feuille en acier ou en polyester 58 dans laquelle on a ménagé deux fenêtres 60 et 62 correspondant à la zone où l'on veut réaliser les bornes de connexion et un tracé 64 correspondant à la forme de la piste conductrice 34 que l'on veut réaliser. Ce tracé 64 est constitué par des microperforations réalisées dans la feuille 58. Ainsi, lors de l'opération de sérigraphie avec l'encre conductrice, on obtiendra ainsi un dépôt d'encre plus important dans les zones 60 et 62 correspondant aux bornes de connexion que pour la partie courante 64 de la métallisation.

Les figures 4a et 4b illustrent un autre mode de réalisation de l'écran de sérigraphie. Dans ce mode de réalisation, on part d'un écran classique constitué par des mailles de fibres 70, par exemple en polyester. Dans la zone où l'on veut obtenir un dépôt d'encre plus important et représentée par le cercle 72 sur la figure 4a, on procède à la soudure des fibres en leurs noeuds 74. Après avoir réalisé la soudure des fibres dans cette zone, on découpe dans l'écran une fenêtre 76 correspondant à la zone exacte où le dépôt d'encre doit être plus important. Bien entendu, la zone 72 dans laquelle on a réalisé la soudure des fibres au niveau de leurs noeuds doit englober la fenêtre 76 à découper.

## Revendications

1. Procédé de réalisation d'un composant électronique du type carte à puce, comprenant un substrat isolant (10) muni de pistes conductrices formant antenne et une puce semi-conductrice (20) montée sur ledit substrat, **caractérisé en ce qu'**il comprend les étapes suivantes :
on réalise par sérigraphie lesdites pistes conductrices formant antenne sur le substrat à l'aide d'une encre conductrice polymérisable,
on fournit ladite puce semi-conductrice munie de plages de contact,
on réalise sur au moins certaines desdites plages des bornes conductrices en relief (26), et
on dispose ladite puce sur le substrat, alors que ladite encre conductrice des pistes conductrices formant antenne n'est pas encore sèche de telle manière que l'extrémité desdites bornes pénètre dans l'encre aux emplacements correspondants.

2. Procédé selon la revendication 1, **caractérisé en ce que** on fixe mécaniquement ladite puce sur ledit substrat par polymérisation d'une résine adhésive isolante disposée entre la face inférieure de la puce et la face supérieure du substrat.

3. Procédé selon la revendication 2. **caractérisé en ce que** ladite résine adhésive est disposée entre le substrat et la puce après la mise en place de la puce sur le substrat.

4. Procédé selon la revendication 2, **caractérisé en ce que** ladite résine adhésive isolante est disposée sur la face inférieure de la puce avant la mise en place de la puce sur le substrat.

5. Procédé selon l'une quelconque des revendications 1 à 4, **caractérisé en ce que** les bornes de contact en relief sont réalisées par sérigraphie sur la face inférieure de la puce.

6. Procédé selon l'une quelconque des revendications 1 à 5, **caractérisé en ce que**, pour la réalisation des pistes conductrices par sérigraphie, on utilise comme écran une feuille dans laquelle les zones correspondant aux pistes sont définies par des micro-perforations et celles correspondant aux plages de connexion sont définies par des fenêtres.

7. Procédé selon l'une quelconque des revendications 1 à 5, **caractérisé en ce que**, pour réaliser l'écran de sérigraphie des pistes conductrices et des bornes de connexion, on part d'un écran à maille de fibres en matériau plastique, on soude les fibres entre elles dans la zone qui inclut la surface où on veut réaliser une plage de connexion et on découpe dans ladite zone la portion correspondant à ladite surface.

## Patentansprüche

1. Fertigungsverfahren eines elektronischen Bauteils in der Art einer Chipkarte, die ein Isoliersubstrat (10) mit eine Antenne bildenden Leiterbahnen und einen auf dem besagten Substrat montierten Halbleiterchip (20) umfasst, darin **gekennzeichnet**, dass es folgende Etappen umfasst:
durch Siebdruck werden die besagten, eine Antenne bildenden Leiterbahnen auf dem Substrat mithilfe einer polymerisierbaren leitfähigen Tinte hergestellt,
man stellt den besagten Halbleiterchip mit den Kontaktstellen bereit,
man stellt zumindest auf bestimmten dieser Stellen reliefförmige und leitfähige Klemmen (26) her und
man bringt den besagten Chip auf dem Substrat derartig an, dass während die besagte leitfähige Tinte der die Antenne bildenden Leiterbahnen noch nicht trocken ist, das Ende der besagten Klemmen an den entsprechenden Stellen in die Tinte eindringt.

2. Verfahren nach Anspruch 1, **dadurch gekennzeichnet, dass** man den besagten Chip durch Polymerisieren eines isolierenden Klebeharzes, das zwischen der Unterseite des Chips und der Oberseite des Substrats angebracht wird, auf dem besagten Substrat mechanisch fixiert.

3. Verfahren nach Anspruch 2, **dadurch gekennzeichnet, dass** das besagte Klebeharz nach dem Anbringen des Chips auf dem Substrat zwischen dem Substrat und dem Chip aufgetragen wird.

4. Verfahren nach Anspruch 2, **dadurch gekennzeichnet, dass** das besagte isolierende Klebeharz vor dem Anbringen des Chips auf dem Substrat auf der Unterseite des Chips aufgetragen wird.

5. Verfahren nach einem beliebigen der Ansprüche 1 bis 4, **dadurch gekennzeichnet, dass** die reliefförmigen Kontaktstellen auf der Unterseite des Chips durch Siebdruck realisiert werden.

6. Verfahren nach einem beliebigen der Ansprüche 1 bis 5, **dadurch gekennzeichnet, dass** man zum Herstellen der Leiterbahnen durch Siebdruck als Platte ein Blatt verwendet, in dem die den Bahnen entsprechenden Zonen durch Mikroperforierungen und die den Anschlussbereichen entsprechenden Zonen durch Fenster definiert werden.

7. Verfahren nach einem beliebigen der Ansprüche 1 bis 5, **dadurch gekennzeichnet, dass** man zum Herstellen der Siebdruckplatte für Leiterbahnen und Anschlussklemmen von einer Platte mit Fasermaschen aus Kunststoff ausgeht, man die Fasern in der Zone miteinander verschweißt, die die Fläche enthält, in der man einen Anschlussbereich herstellen möchte und man in der besagten Zone den der besagten Fläche entsprechenden Teil ausschneidet.

## Claims

1. A method of making an electronic component of the chip card type, comprising an insulating substrate(10)provided with antenna-forming conductive tracks, and a semiconductor chip (20) mounted on said substrate, said method being **characterized in that** it comprises the following steps:
said antenna-forming conductive tracks are formed on the substrate by screen printing using a polymerizable conductive ink;
said semiconductor chip as provided with contact areas is supplied;
conductive terminals in relief (26) or "bumps" are formed on at least some of said areas; and
said chip is disposed on the substrate, before said conductive ink is dry, so that the ends of said terminals penetrate into the ink at the corresponding locations.

2. A method according to claim 1, **characterized in that** said chip is fixed mechanically to said substrate by polymerizing an insulating adhesive resin disposed between the bottom face of the chip and the top face of the substrate.

3. A method according to claim 2, **characterized in that** said adhesive resin is disposed between the substrate and the chip after the chip has been put in place on the substrate.

4. A method according to claim 2, **characterized in that** said insulating adhesive resin is disposed on the bottom face of the chip before the chip is put in place on the substrate.

5. A method according to any one of claims 1 to 4, **characterized in that** the contact terminals in relief are formed by screen printing on the bottom face of the chip.

6. A method according to any one of claims 1 to 5, **characterized in that**, for forming the conductive tracks by screen printing, a sheet is used in which the zones corresponding to the tracks are defined by micro-perforations, and the zones corresponding to the connection areas are defined by windows.

7. A method according to any one of claims 1 to 5, **characterized in that**, for forming the screen for screen printing the conductive tracks and the connection terminals, a screen made up of a mesh of plastics fibers is used, the fibers are welded together in the zone that includes the area in which a connection area is to be formed, and the portion corresponding to said area is cut out from said zone.
